# EUROPEAN PATENT APPLICATION

(11) **EP 4 787 260 A1**
(43) Date of publication of application: **05.08.2026**
(21) Application number: 24870379.5
(22) Date of filing: 04.09.2024
(51) Int. Cl.: G06Q 10/087

(54) **LANE LAYOUT METHOD AND APPARATUS, ELECTRONIC DEVICE, AND STORAGE MEDIUM**

(30) Priority: 25.09.2023 CN 202311242869
(71) Applicant: Hangzhou Hikrobot Co., Ltd., Hangzhou, Zhejiang 310051 (CN)
(72) Inventor: ZHANG, Zhiyu, Hangzhou, Zhejiang 310051 (CN); WU, Yingying, Hangzhou, Zhejiang 310051 (CN); XU, Zhijun, Hangzhou, Zhejiang 310051 (CN)
(74) Representative: Schmitz, Joseph
(86) International application number: PCT/CN2024/116900
(87) International publication number: WO 2025/066833

(57) **Abstract**

Embodiments of the present application provide a lane layout method and apparatus, an electronic device, and a storage medium. The method comprises: obtaining region distribution information of a warehouse region to be laid out and a goods taking and placing rule; on the basis of the location of a storage region and the locations of obstacles, determining storage positions in the storage region and storage positions in an obstacle region which is located between two obstacles and does not belong to any storage region; for each obstacle region, according to a lane layout rule that matches the goods taking and placing rule, performing lane layout on a target adjacent storage position of the obstacle region and at least one storage position in the obstacle region, and obtaining a first-type of laid out lanes. By using the method provided in the embodiments of the present application, the utilization rate of the storage space of a warehouse can be improved.

## Description

The present application claims priority to Chinese patent application 202311242869.2 filed with the China National Intellectual Property Administration (CNIPA) on September 25, 2023 and entitled "AISLE LAYOUT METHOD, APPARATUS, ELECTRONIC DEVICE, AND STORAGE MEDIUM", which is incorporated herein by reference in its entirety.

### Technical Field

The present application relates to the technical field of warehousing and logistics, and in particular to an aisle layout method, apparatus, electronic device, and storage medium.

### Background

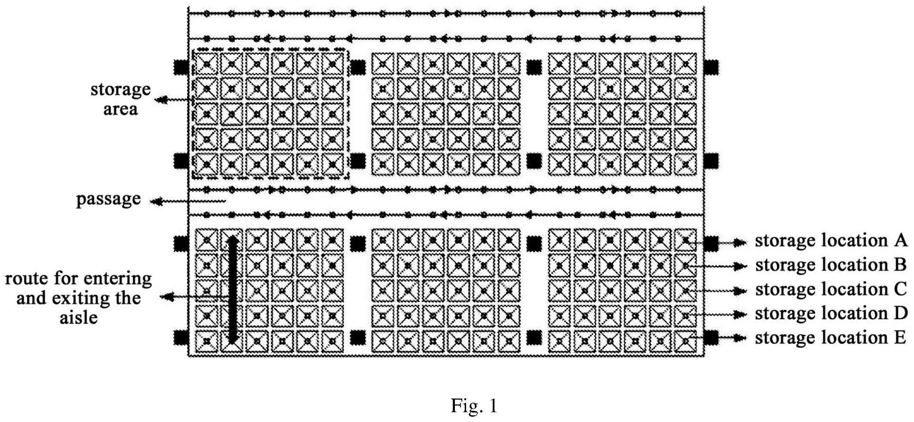

In the field of warehousing and logistics, warehouses usually adopt intensive storage to improve space utilization, and aisle storage is a layout manner for intensive storage in warehouses. As shown in Fig. 1, in a warehouse area adopting aisle storage, it at least includes a storage area for storing goods and a passage for people or mobile robots to walk.

In related aisle layout method, as shown in Fig. 1, multiple storage locations may be set in the storage area, and each column of adjacent storage locations is determined as one aisle, that is to say, each aisle is composed of multiple storage locations in one column, and people or mobile robots may enter and exit the aisle through the passage and pick or place goods within the aisle following a route for entering and exiting the aisle.

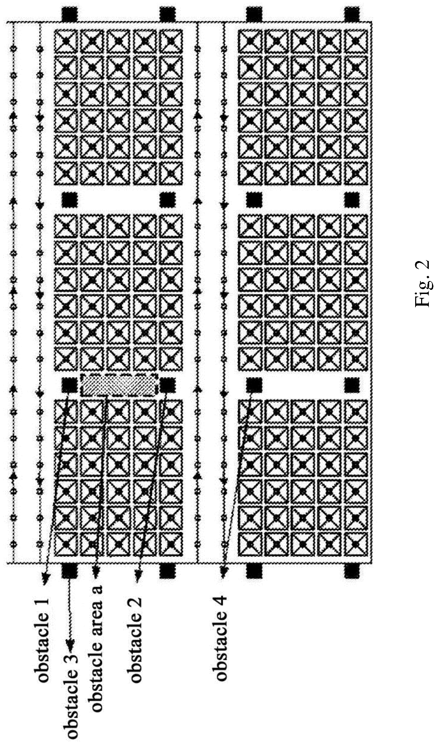

However, there are usually obstacles such as load-bearing columns in the warehouse area, and there may be obstacle areas between some obstacles, for example, there is an obstacle area *a* between obstacle 1 and obstacle 2 in Fig. 2. Therefore, applying existing aisle layout methods will result in the obstacle areas being unable to store goods, thereby leading to low utilization of the storage space of the warehouse. That is to say, applying existing aisle layout methods, the space utilization of areas in the warehouse other than passages is low.

### Summary

The purpose of embodiments of the present application is to provide an aisle layout method, apparatus, electronic device, and storage medium, so as to improve the utilization of the storage space of the warehouse. The specific technical solutions are as follows:
In a first aspect, an embodiment of the present application provides an aisle layout method, the method includes:
acquiring area distribution information and a rule for picking and placing goods of a warehouse area to be laid out; wherein the area distribution information includes: a passage position, a storage area position, and an obstacle position;
determining each storage location located in a storage area and each storage location located in an obstacle area between two obstacles and not belonging to any of storage areas according to the storage area position and the obstacle position;
performing, for each obstacle area, aisle layout on target adjacent storage locations of the obstacle area and at least one storage location in the obstacle area according to an aisle layout rule matching the rule for picking and placing goods, to obtain a laid-out first-type aisle;
wherein the target adjacent storage locations of each obstacle area comprise: each storage location located in an adjacent storage area on a designated side of the obstacle area, which is adjacent to the obstacle area and arranged in an arrangement direction of storage locations in the obstacle area; a shape of the first-type aisle includes at least one of: a concave shape, an L shape, and a U shape.

Optionally, in a specific implementation, the performing, for each obstacle area, aisle layout on target adjacent storage locations of the obstacle area and at least one storage location in the obstacle area according to an aisle layout rule matching the rule for picking and placing goods, to obtain a laid-out first-type aisle, includes:
with the rule for picking and placing goods being first-in first-out, for each obstacle area, performing aisle layout on the target adjacent storage locations of the obstacle area and each storage location in the obstacle area according to an aisle layout rule of a first-type shape, to obtain the laid-out first-type aisle; wherein the first-type shape includes: a concave shape;
with the rule for picking and placing goods being first-in last-out, for each obstacle area, performing aisle layout on the target adjacent storage locations of the obstacle area and each storage location in the obstacle area according to an aisle layout rule of a second-type shape, to obtain the laid-out first-type aisle; wherein the second-type shape includes: a U shape, and/or, an L shape.

Optionally, in a specific implementation, the performing aisle layout on the target adjacent storage locations of the obstacle area and each storage location in the obstacle area according to an aisle layout rule of a first-type shape, to obtain the laid-out first-type aisle, includes:
determining any storage location, among the target adjacent storage locations of the obstacle area, that is adjacent to the passage position as a target aisle head;
determining a storage location, among the target adjacent storage locations, that is adjacent to the passage position other than the target aisle head as a target aisle tail;
determining, from among the target adjacent storage locations and each storage location in the obstacle area, each of target storage locations connecting the target aisle head and the target aisle tail and satisfying the rule for picking and placing goods, to obtain the laid-out first-type aisle of a concave shape; wherein the target storage locations comprise at least one storage location in the obstacle area.

Optionally, in a specific implementation, the performing aisle layout on the target adjacent storage locations of the obstacle area and each storage location in the obstacle area according to an aisle layout rule of a second-type shape, to obtain the laid-out first-type aisle, includes:
determining any storage location, among the target adjacent storage locations of the obstacle area, that is adjacent to the passage position as a target aisle head;
determining any storage location among storage locations in the obstacle area as a target aisle tail;
determining, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or an L shape; wherein the target storage locations comprise: all storage locations in the designated direction; the designated direction is: a direction from the target aisle tail pointing to an obstacle in the obstacle area that is farthest from the target aisle head.

Optionally, in a specific implementation, the determining any storage location among storage locations in the obstacle area as the target aisle tail, includes:
determining, from among the storage locations in the obstacle area, a storage location that is adjacent to an obstacle in the obstacle area and is closest to the target aisle head as the target aisle tail; wherein the shape of the obtained first-type aisle is the U shape;
   or,
determining, from among the storage locations in the obstacle area, a storage location that is adjacent to an obstacle in the obstacle area and is farthest from the target aisle head as the target aisle tail; wherein the shape of the obtained first-type aisle is the L shape.

Optionally, in a specific implementation, the determining, from among the storage locations in the obstacle area, a storage location that is adjacent to an obstacle in the obstacle area and is closest to the target aisle head as the target aisle tail, includes:
in response to determining that a quantity of storage locations in the obstacle area is less than or equal to a designated quantity, determining, from among the storage locations in the obstacle area, a storage location that is adjacent to an obstacle in the obstacle area and is closest to the target aisle head as the target aisle tail;
the method further includes:
   in response to determining that the quantity of storage locations in the obstacle area is greater than the designated quantity, determining, from among the storage locations in the obstacle area, a storage location spaced from an obstacle closest to the target aisle head by a target quantity of storage locations as the target aisle tail; wherein the target quantity is: a difference between the quantity of storage locations and the designated quantity, and the shape of the obtained first-type aisle is the U shape or the L shape.

Optionally, in a specific implementation, the method further includes:
performing, for each storage area, aisle division on each storage location in the storage area that has not been determined as a target storage location based on the rule for picking and placing goods and the passage position, to obtain each laid-out second-type aisle.

Optionally, in a specific implementation, the rule for picking and placing goods is first-in first-out;
the performing, for each storage area, aisle division on each storage location in the storage area that has not been determined as a target storage location based on the rule for picking and placing goods and the passage position, to obtain a laid-out second-type aisle, includes:
for each storage area, in response to determining that the storage area contains any of the target adjacent storage locations, dividing storage locations in the storage area into multiple groups of storage locations according to the arrangement direction; and dividing each group of storage locations that does not contain any of the target adjacent storage locations as a same aisle, to obtain each laid-out second-type aisle;
for each storage area, in response to determining that the storage area does not contain any of the target adjacent storage locations, dividing storage locations in the storage area into multiple groups of storage locations according to the arrangement direction; and dividing each group of storage locations as a same aisle, to obtain each laid-out second-type aisle.
Optionally, in a specific implementation, the rule for picking and placing goods is first-in last-out, and there is an idle storage location among the target adjacent storage locations that has not been divided as the target storage location;
the performing, for each storage area, aisle division on each storage location in the storage area that has not been determined as the target storage location based on the rule for picking and placing goods and the passage position, to obtain each laid-out second-type aisle, includes:
for each storage area, in response to determining that the storage area contains any of the target adjacent storage locations, dividing storage locations in the storage area into multiple groups of storage locations according to the arrangement direction; dividing the idle storage location and a group of storage locations adjacent to the idle storage location as a same L-shaped aisle, and dividing each group of storage locations that does not contain any of the target adjacent storage locations as a same aisle, to obtain each laid-out second-type aisle;
for each storage area, in response to determining that the storage area does not contain any of the target adjacent storage locations, dividing storage locations in the storage area into multiple groups of storage locations according to the arrangement direction; and dividing each group of storage locations as a same aisle, to obtain each laid-out second-type aisle.

In a second aspect, an embodiment of the present application provides an aisle layout apparatus, the apparatus includes:
an information acquisition module, configured to acquire area distribution information and a rule for picking and placing goods of a warehouse area to be laid out; wherein the area distribution information includes: a passage position, a storage area position, and an obstacle position;
a storage location determination module, configured to determine each storage location located in a storage area and each storage location located in an obstacle area between two obstacles and not belonging to any of storage areas according to the storage area position and the obstacle position;
an aisle layout module, configured to perform, for each obstacle area, aisle layout on target adjacent storage locations of the obstacle area and at least one storage location in the obstacle area according to an aisle layout rule matching the rule for picking and placing goods, to obtain a laid-out first-type aisle; wherein the target adjacent storage locations of each obstacle area comprise: each storage location located in an adjacent storage area on a designated side of the obstacle area, which is adjacent to the obstacle area and arranged according to an arrangement direction of storage locations in the obstacle area; a shape of the first-type aisle includes at least one of: a concave shape, an L shape, and a U shape.

Optionally, in a specific implementation, the aisle layout module includes:
a first layout sub-module, configured to, with the rule for picking and placing goods being first-in first-out, for each obstacle area, perform aisle layout on the target adjacent storage locations of the obstacle area and each storage location in the obstacle area according to an aisle layout rule of a first-type shape, to obtain the laid-out first-type aisle; wherein the first-type shape includes: a concave shape;
a second layout sub-module, configured to, with the rule for picking and placing goods being first-in last-out, for each obstacle area, perform aisle layout on the target adjacent storage locations of the obstacle area and each storage location in the obstacle area according to an aisle layout rule of a second-type shape, to obtain the laid-out first-type aisle; wherein the second-type shape includes: a U shape, and/or, an L shape.

Optionally, in a specific implementation, the first layout sub-module is specifically configured to:
determine any storage location adjacent to the passage position among the target adjacent storage locations of the obstacle area as a target aisle head;
determine storage locations adjacent to the passage position other than the target aisle head among the target adjacent storage locations as a target aisle tail;
determine each target storage location connecting the target aisle head and the target aisle tail and satisfying the rule for picking and placing goods among the target adjacent storage locations and each storage location in the obstacle area, to obtain the laid-out first-type aisle of the concave shape; wherein the target storage locations include at least one storage location in the obstacle area.

Optionally, in a specific implementation, the second layout sub-module includes:
an aisle head determination unit, configured to determine any storage location, among the target adjacent storage locations of the obstacle area, that is adjacent to the passage position as a target aisle head;
an aisle tail determination unit, configured to determine any storage location among storage locations in the obstacle area as a target aisle tail;
an aisle determination unit, configured to determine, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or a L shape; wherein the target storage locations comprise: all storage locations in the designated direction; the designated direction is: a direction from the target aisle tail pointing to an obstacle in the obstacle area that is farthest from the target aisle head.

Optionally, in a specific implementation, the aisle tail determination unit includes:
a first determination sub-unit, configured to determine, from among the storage locations in the obstacle area, a storage location that is adjacent to an obstacle in the obstacle area and is closest to the target aisle head as the target aisle tail; wherein the shape of the obtained first-type aisle is the U shape;
   or,
a second determination sub-unit, configured to determine, from among the storage locations in the obstacle area, a storage location that is adjacent to an obstacle in the obstacle area and is farthest from the target aisle head as the target aisle tail; wherein the shape of the obtained first-type aisle is the L shape.

Optionally, in a specific implementation, the first determination sub-unit is specifically configured to:
in response to determining that a quantity of storage locations in the obstacle area is less than or equal to a designated quantity, determine, from among the storage locations in the obstacle area, a storage location that is adjacent to an obstacle in the obstacle area and is closest to the target aisle head as the target aisle tail;
the apparatus further includes:
   an aisle tail determination module, configured to, in response to determining that the quantity of storage locations in the obstacle area is greater than the designated quantity, determine, from among the storage locations in the obstacle area, a storage location spaced from an obstacle closest to the target aisle head by a target quantity of storage locations as the target aisle tail; wherein the target quantity is: a difference between the quantity of storage locations and the designated quantity, and the shape of the obtained first-type aisle is the U shape, or, the L shape.

Optionally, in a specific implementation, the apparatus further includes:
an aisle division module, configured to, for each storage area, perform aisle division on each storage location in the storage area that has not been determined as a target storage location based on the rule for picking and placing goods and the passage position, to obtain each laid-out second-type aisle.

Optionally, in a specific implementation, the rule for picking and placing goods is first-in first-out;
the aisle division module is specifically configured to:
for each storage area, in response to determining that the storage area contains any of the target adjacent storage locations, divide storage locations in the storage area into multiple groups of storage locations according to the arrangement direction; and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

Optionally, in a specific implementation, the rule for picking and placing goods is first-in last-out, and there is an idle storage location among the target adjacent storage locations that has not been divided as the target storage location;
the aisle division module is specifically configured to:
for each storage area, in response to determining that the storage area contains any of the target adjacent storage locations, divide each storage location in the storage area into multiple groups of storage locations according to the arrangement direction; divide the idle storage location and an group of storage locations adjacent to the idle storage location as a same L-shaped aisle, and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

In a third aspect, an embodiment of the present application provides an electronic device, including:
a memory, configured to store a computer program;
a processor, configured to execute the program stored in the memory to implement any one of the aforementioned aisle layout methods.

In a fourth aspect, an embodiment of the present application provides a computer-readable storage medium, the computer-readable storage medium has a computer program stored therein, wherein the computer program, when executed by a processor, implements any one of the aforementioned aisle layout methods.

In a fifth aspect, an embodiment of the present application provides a computer program product containing instructions, when the computer program product is running on a computer, causing the computer to execute any one of the aforementioned aisle layout methods.

Beneficial effects of the embodiments of the present application:
It can be seen from the above, by applying the solution provided in the embodiments of the present application, when performing aisle layout on a warehouse area to be laid out, a storage location located in an obstacle area between two obstacles and not belonging to any storage area may be determined, and further, the storage location in the obstacle area may be laid out into an aisle by utilizing storage locations in a storage area adjacent to the obstacle area, that is, the aisle including storage locations located in the obstacle area between two obstacles and not belonging to any storage area may be laid out in the aforementioned warehouse area, so that the obstacle area may also be used for storing goods, thereby improving the utilization of the storage space of the warehouse.

### Brief Description of the Drawings

The drawings described here are used to provide further understanding for the present application and constitute a part of the present application. The schematic embodiments and descriptions of the present application are used to explain the present application and do not constitute an improper limitation for the present application.
Fig. 1 is a schematic diagram of area distribution of a warehouse area provided by an embodiment of the present application;
Fig. 2 is a schematic diagram of an obstacle area provided by an embodiment of the present application;
Fig. 3 is a flow chart of an aisle layout method provided by an embodiment of the present application;
Fig. 4 is a schematic diagram of an aisle layout provided by an embodiment of the present application;
Fig. 5a is a schematic diagram of a first concave-shaped aisle segment provided by an embodiment of the present application;
Fig. 5b is a schematic diagram of a second concave-shaped aisle segment provided by an embodiment of the present application;
Fig. 6a is a schematic diagram of a U-shaped aisle provided by an embodiment of the present application;
Fig. 6b is a schematic diagram of an L-shaped aisle provided by an embodiment of the present application;
Fig. 6c is a schematic diagram of another aisle layout provided by an embodiment of the present application;
Fig. 7 is a structural schematic diagram of an aisle layout apparatus provided by an embodiment of the present application;
Fig. 8 is a structural schematic diagram of an electronic device provided by an embodiment of the present application.

### Detailed Description

In order to make the objective, technical solutions and advantages of the present application clearer and more understandable, the present application will be described in more detail below with reference to the accompanying drawings and embodiments. Obviously, the described embodiments are only some, and not all, of the embodiments of the present application. All other embodiments obtained based on the embodiments of the present application by those skilled in the art fall into the scope of protection of the present application.

In related aisle layout methods, multiple storage locations may be set in a storage area, and each column of adjacent storage locations is determined as one aisle, and people or mobile robots may enter and exit the aisle through a passage and pick or place goods within the aisle following a route for entering and exiting the aisle. However, there are usually obstacles such as load-bearing columns in the warehouse area, and there may be obstacle areas between some obstacles. Applying existing aisle layout methods will result in the obstacle areas being unable to store goods, thereby leading to low utilization of the storage space of the warehouse.

To solve the above problem, an embodiment of the present application provides an aisle layout method.

Wherein, the method may be applied to various scenarios requiring aisle layout, for example, a scenario of performing aisle layout on a warehouse area with obstacles such as load-bearing columns. Furthermore, the execution entity of the embodiments of the present application may be various kinds of electronic devices having data processing functions, such as mobile phone, laptop computer, desktop computer, etc., hereinafter referred to as electronic device. Moreover, the electronic device may be an independent electronic device or a device cluster composed of multiple electronic devices. Based on this, the embodiments of the present application do not limit the specific application scenario and execution entity of the method. That is, in the field of warehousing and logistics, when adopting intensive storage in a warehouse, the method can be used to perform aisle layout on the warehouse, so as to utilize obstacle areas between obstacles in the warehouse for storing goods, thereby improving the utilization of the storage space of the warehouse.

The aisle layout method provided by an embodiment of the present application may include the following steps:
acquiring area distribution information and a rule for picking and placing goods of a warehouse area to be laid out; wherein the area distribution information includes: a passage position, a storage area position, and an obstacle position;
determining each storage location located in a storage area and each storage location located in an obstacle area between two obstacles and not belonging to any of storage areas according to the storage area position and the obstacle position;
for each obstacle area, performing aisle layout on target adjacent storage locations of the obstacle area and at least one storage location in the obstacle area according to an aisle layout rule matching the rule for picking and placing goods, to obtain a laid-out first-type aisle;
wherein the target adjacent storage locations of each obstacle area include: each storage location located in an adjacent storage area on a designated side of the obstacle area, which is adjacent to the obstacle area and arranged in an arrangement direction of storage locations in the obstacle area; a shape of the first-type aisle includes at least one of: a concave shape, an L shape, and a U shape.

It can be seen from the above, by applying the solution provided in the embodiments of the present application, when performing aisle layout on a warehouse area to be laid out, a storage location located in an obstacle area between two obstacles and not belonging to any storage area may be determined, and further, the storage location in the obstacle area may be laid out into an aisle by utilizing storage locations in a storage area adjacent to the obstacle area, that is, the aisle including storage locations located in the obstacle area between two obstacles and not belonging to any storage area may be laid out in the aforementioned warehouse area, so that the obstacle area may also be used for storing goods, thereby improving the utilization of the storage space of the warehouse.

Below, in combination with the accompanying drawings, the aisle layout method provided by an embodiment of the present application is specifically described.

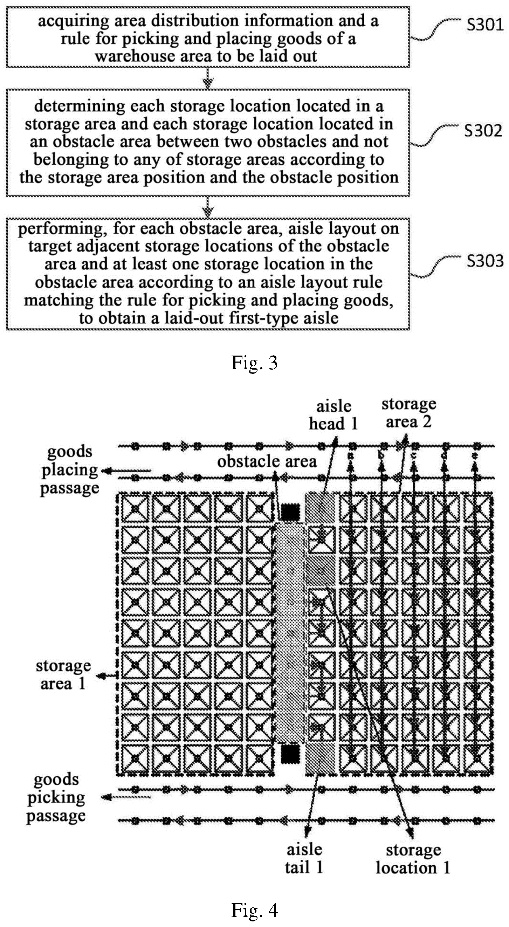

Fig. 3 is a flow chart of an aisle layout method provided by an embodiment of the present application. As shown in Fig. 3, the method may include the following steps S301-S303.

S301: acquiring area distribution information and a rule for picking and placing goods of a warehouse area to be laid out.

Wherein, the area distribution information includes: a passage position, a storage area position, and an obstacle position.

The warehouse area to be laid out is a warehouse area that requires aisle layout to achieve goods storage and retrieval based on aisles. The warehouse area may be a warehouse area that has never undergone aisle layout, or a warehouse area that has undergone aisle layout before but needs re-layout due to reasons such as unreasonable previous aisle layout. This is reasonable.

When performing aisle layout on the warehouse area to be laid out, the passage position, storage area position, obstacle position, and other area distribution information of the warehouse area to be laid out, as well as the rule for picking and placing goods of the warehouse area to be laid out, can be acquired first.

Optionally, a person skilled in the art may mark the passage position, storage area position, obstacle position, and other area distribution information of the warehouse area to be laid out on a plan view of the warehouse area. Then, when performing aisle layout on the warehouse area to be laid out, the electronic device may acquire the above plan view with marked area distribution information, and determine the passage position, storage area position, obstacle position, and other area distribution information of the warehouse area to be laid out based on the above plan view.

Optionally, an image acquisition device may be set in the warehouse area to be laid out to collect scene images of the warehouse system to be laid out. Thus, the electronic device may acquire one or more scene images that can cover the complete area of the warehouse area to be laid out, perform area recognition on the scene images to determine areas such as the passage area, storage area, and obstacle area in the warehouse area to be laid out, and then determine the passage position, storage area position, obstacle position, and other area distribution information of the warehouse area to be laid out according to the above recognition result.

Of course, the electronic device may also acquire the area distribution information of the warehouse area to be laid out through other ways. For example, the electronic device may acquire and display a plan view of the warehouse area to be laid out, and the person skilled in the art may mark the passage position, storage area position, obstacle position, and other area distribution information of the warehouse area to be laid out on the above plan view displayed by the electronic device through a touch screen, mouse click, and other ways, thereby the electronic device may acquire the area distribution information obtained based on the above personnel operations. This is reasonable.

Wherein, the rule for picking and placing goods may be first-in first-out or first-in last-out, and the rule for picking and placing goods is for the entire warehouse area to be laid out, that is, the rule for picking and placing goods for each aisle laid out in the warehouse area to be laid out is the same, either all first-in first-out or all first-in last-out. The rule for picking and placing goods of the warehouse area to be laid out may be determined by the person skilled in the art according to actual application situations, such as the warehouse-in and warehouse-out frequency of goods to be stored, the storage duration of goods to be stored, etc., which is not specifically limited in the embodiments of the present application.

When the rule for picking and placing goods is the first-in first-out rule, for each aisle, goods are usually placed in the aisle in the order from the aisle tail to the aisle head; and goods are picked up from the aisle in the order from the aisle tail to the aisle head.

For example, for an aisle composed of storage location A, storage location B, storage location C, storage location D, and storage location E as shown in Fig. 1, if the rule for picking and placing goods is the first-in first-out rule, the aisle head is storage location A, and the aisle tail is storage location E, then for this aisle, when placing goods, a person or mobile robot enters the aisle from storage location A, first places goods in storage location E, then places goods in storage location D, storage location C, and storage location B in sequence, and finally places goods in storage location A; when picking up goods, the person or mobile robot enters the aisle from storage location E, first picks up the goods in storage location E, then picks up the goods in storage location D, storage location C, and storage location B in sequence, and finally picks up the goods in storage location A.

When the rule for picking and placing goods is the first-in last-out rule, for each aisle, goods are usually placed in the aisle in the order from the aisle tail to the aisle head; and goods are picked up from the aisle in the order from the aisle head to the aisle tail.

For example, for the aisle composed of storage location A, storage location B, storage location C, storage location D, and storage location E as shown in Fig. 1, if the rule for picking and placing goods is the first-in last-out rule, the aisle head is storage location A, and the aisle tail is storage location E, then for this aisle, when placing goods, a person or mobile robot enters the aisle from storage location A, first places goods in storage location E, then places goods in storage location D, storage location C, and storage location B in sequence, and finally places goods in storage location A; when picking up goods, the person or mobile robot still enters the aisle from storage location A, first picks up the goods in storage location A, then picks up the goods in storage location B, storage location C, and storage location D in sequence, and finally picks up the goods in storage location E.

In summary, in the present application, the so-called aisle head is a storage location that a person or mobile robot first reaches each time when entering the aisle from the passage during the process of placing goods in the aisle, and the so-called aisle head is also the last storage location used for placing goods, that is, the aisle head is adjacent to the passage; correspondingly, the so-called aisle tail is a storage location that is first used for placing goods during the process of placing goods in the aisle, and when the rule for picking and placing goods is first-in first-out, the aisle tail is adjacent to the passage, while when the rule for picking and placing goods is first-in last-out, the aisle tail may be adjacent to the passage or not adjacent to the passage.

Wherein, the so-called storage location being adjacent to the passage means: the storage location is connected to the passage, and a person or mobile robot can directly enter the storage location adjacent to the passage from the passage without passing through other areas.

S302: determining each storage location located in a storage area and each storage location located in an obstacle area between two obstacles and not belonging to any of storage areas according to the storage area position and the obstacle position.

After acquiring the passage position, storage area position, obstacle position, and other area distribution information of the warehouse area to be laid out, each storage location located in the storage area may be determined according to the storage area position; further, the location of the obstacle area located between two obstacles and not belonging to any storage area may be determined according to the storage area position and the obstacle position, and each storage location in the obstacle area may be determined.

Usually, for the warehouse area to be laid out, the type of goods to be stored, the size of the goods, and other goods information may be known in advance, and then warehousing requirements such as temperature, humidity, the type of shelves, etc., of the warehouse area, and storage location information such as the size of each storage location in the warehouse area may be determined based on the above goods information.

Thus, for a storage area in the warehouse area to be laid out, which is an area specially planned for setting storage locations, thus after acquiring the area distribution information of the warehouse area to be laid out, the storage area in the warehouse area to be laid out may be directly determined according to the storage area position. Then, based on the size of the storage location and other storage location information, the storage area can be divided into storage locations to determine each storage location in the storage area.

In addition, for obstacles in the warehouse area to be laid out, the electronic device may determine adjacent two obstacles according to the acquired obstacle position. Wherein, the so-called adjacent two obstacles refer to: two obstacles located on the same straight line without other obstacles between them. Then, the area between the adjacent two obstacles is determined. Since the electronic device simultaneously acquires storage area positions in the warehouse area to be laid out, for every two adjacent obstacles, the electronic device may determine whether an area between the adjacent two obstacles has an overlapping area with a storage area according to the above storage area positions, and determine whether the area between the adjacent two obstacles has an overlapping area with a passage. If the area between the adjacent two obstacles does not have an overlapping area with all storage areas and passages, then the area between the adjacent two obstacles is an obstacle area.

That is, in the present application, the so-called obstacle area is an area located between two obstacles, not belonging to any storage area and not belonging to a passage.

For example, as shown in Fig. 2, there is an obstacle area a between vertically adjacent obstacle 1 and obstacle 2, an area between horizontally adjacent obstacle 1 and obstacle 3 belongs to a storage area, not an obstacle area, an area between diagonally adjacent obstacle 3 and an obstacle belongs to a storage area, not an obstacle area, and an area between vertically adjacent obstacle 2 and obstacle 4 belongs to a passage, not an obstacle area.

Taking the obstacle area shown in Fig. 2 as an example, it can be seen that for the obstacle area, due to the obstruction of the obstacles, a person or mobile robot cannot directly enter the obstacle area through a passage without passing through a storage area.

Thus, in the present application, for the obstacles in the warehouse area to be laid out, after acquiring the area distribution information of the warehouse area to be laid out, an obstacle area may be determined according to the above area distribution information. Further, in order to utilize the above determined obstacle area for goods storage to improve the utilization of the storage space of the warehouse, based on the size of the storage location and other storage location information, the above obstacle area can be divided into storage locations to determine each storage location in the above obstacle area.

Optionally, in a specific implementation, the length and width of the storage location are known, and then each storage location located in the storage area and in the obstacle area may be determined according to the length and width of the storage location, the storage area position, and the obstacle area location.

For example, the length and width of the storage location may both be 1 meter, and the storage area may be determined to be a rectangular area with a length of 4 meters and a width of 3 meters according to the storage area position, and then 4 columns of storage locations may be arranged along the length direction of the storage area, and 3 rows of storage locations may be arranged along the width direction of the storage area, thereby determining 12 storage locations in the storage area.

For example, the length and width of a storage location may both be 1 meter, and an obstacle area may be determined to be a rectangular area with a length of 4 meters and a width of 1 meter according to the obstacle area location, and then 4 columns of storage locations may be arranged along the length direction of the obstacle area, and 1 row of storage locations may be arranged along the width direction of the obstacle area, thereby determining 4 storage locations in the obstacle area.

Optionally, when determining storage locations in the storage area and the obstacle area, the storage locations in the obstacle area may be aligned with the storage locations in the storage area. That is, for each storage location in the obstacle area and the storage area, the horizontal coordinates or vertical coordinates of the center points of every two adjacent storage locations may be the same.

Optionally, in a specific implementation, the size information of the goods and the carrier information of the goods may be acquired, and the size of the storage location may be determined according to the size information of the goods and the carrier information of the goods.

Optionally, the size of the storage location may be larger than the size of the goods and the size of the mobile robot carrying the goods, so that the mobile robot may more easily pick and place goods from the storage location.

S303: performing, for each obstacle area, aisle layout on target adjacent storage locations of the obstacle area and at least one storage location in the obstacle area according to an aisle layout rule matching the rule for picking and placing goods, to obtain a laid-out first-type aisle.

Wherein, the target adjacent storage locations of each obstacle area may include: each storage location located in an adjacent storage area on a designated side of the obstacle area, which is adjacent to the obstacle area and arranged in an arrangement direction of storage locations in the obstacle area; a shape of the first-type aisle may include at least one of a concave shape, an L shape, and a U shape.

In the present application, the so-called aisle layout refers to: determining, from among storage locations in the storage area and the obstacle area, a target aisle head and a target aisle tail belonging to the same aisle, and target storage locations connecting the above target aisle head and target aisle tail, dividing the above target aisle head, target aisle tail, and the target storage locations as storage locations in the same aisle, to obtain an aisle starting from the above target aisle head, sequentially passing through the above each target storage locations, and ending at the above target aisle tail. Wherein, each laid-out first-type aisle includes storage locations located in the obstacle area.

Since when placing goods in an aisle, a person or mobile robot needs to enter the aisle head of each aisle through a passage in the warehouse area, the aisle head is usually a storage location adjacent to the passage in the warehouse area. When picking up goods in an aisle, a person or mobile robot needs to enter the aisle head or aisle tail of each aisle through a passage in the warehouse area, therefore, there is also a possibility that the aisle tail is adjacent to the passage in the warehouse area. However, under the influence of obstacles, there are usually no storage locations adjacent to a passage in the obstacle area, but for each obstacle area, in the adjacent storage areas of the obstacle area, among the storage locations which are adjacent to the obstacle area and arranged in the arrangement direction of storage locations in the obstacle area, there are usually storage location adjacent to a passage. Therefore, by means of the storage locations adjacent to the passage in the adjacent storage area of the obstacle area, the connection between the storage locations in the obstacle area and the passage may be achieved, enabling a person or mobile robot to enter the obstacle area from the passage through the storage area. Thus, the storage locations in the obstacle area can be laid out into an aisle for goods picking and placing.

Usually, depending on the location of the obstacle area, the obstacle area may have one adjacent storage area or two adjacent storage areas, so a designated side may be set first, so as to determine the target adjacent storage locations in the adjacent storage area on the designated side of the obstacle area.

Therefore, after determining each storage location in the storage area and in the obstacle area, for each obstacle area, storage locations located in the adjacent storage area on the designated side of the obstacle area, which are adjacent to the obstacle area and arranged in the arrangement direction of storage locations in the obstacle area may be determined as the target adjacent storage locations of the obstacle area.

For example, as shown in Fig. 4, for an obstacle area in Fig. 4, the storage locations in the adjacent storage area on the right side of this obstacle area, that is, one column of storage locations adjacent to this obstacle area in storage area 2, may be determined as the target adjacent storage locations of the obstacle area. That is, the leftmost column of storage locations in storage area 2 is determined as the target adjacent storage locations of the obstacle area.

Furthermore, for each obstacle area, aisle layout may be performed on the target adjacent storage locations of the obstacle area and at least one storage location in the obstacle area according to an aisle layout rule matching the rule for picking and placing goods, thereby obtaining the laid-out first-type aisle. In the first-type aisle, the storage locations in the obstacle area may be connected to the passage through the target adjacent storage locations of the obstacle area, and a person or mobile robot may enter the obstacle area through the passage and the target adjacent storage locations in the first-type aisle.

That is to say, for the first-type aisle, a person or mobile robot may enter the above target adjacent storage locations from the passage, and then enter the storage locations in the obstacle area from the above target adjacent storage locations; correspondingly, after entering the storage locations in the obstacle area, the person or mobile robot can return to the above target adjacent storage locations from the storage locations in the obstacle area, and enter the passage from the above target adjacent storage locations, thus leaving the above first-type aisle.

It can be seen from the above, for each obstacle area, by means of the target adjacent storage locations of the obstacle area, the connection between the passage and the storage locations in the obstacle area may be achieved, enabling the storage locations in the obstacle area are laid out into an aisle. According to the above first-in first-out rule for picking and placing goods and the first-in last-out rule for picking and placing goods, when performing aisle layout, it is necessary to consider the storage locations adjacent to the passage in the target adjacent storage locations of the obstacle area. That is to say, when performing aisle layout, not only the different requirements of different rule for picking and placing goods on whether the aisle head and aisle tail in the aisle need to be adjacent to a passage, but also the positional relationship between the target adjacent storage locations of the obstacle area and the passage need to be considered.

Based on this, in the present application, in the above step S303, for each obstacle area, performing aisle layout on the target adjacent storage locations of the obstacle area and at least one storage location in the obstacle area according to an aisle layout rule matching the rule for picking and placing goods is essentially: for each obstacle area, performing aisle layout on the target adjacent storage locations of the obstacle area and at least one storage location in the obstacle area according to an aisle layout rule matching the rule for picking and placing goods and based on the passage position of the warehouse area to be laid out.

Wherein, the shape of the first-type aisle includes at least one of a concave shape, an L shape, and a U shape.

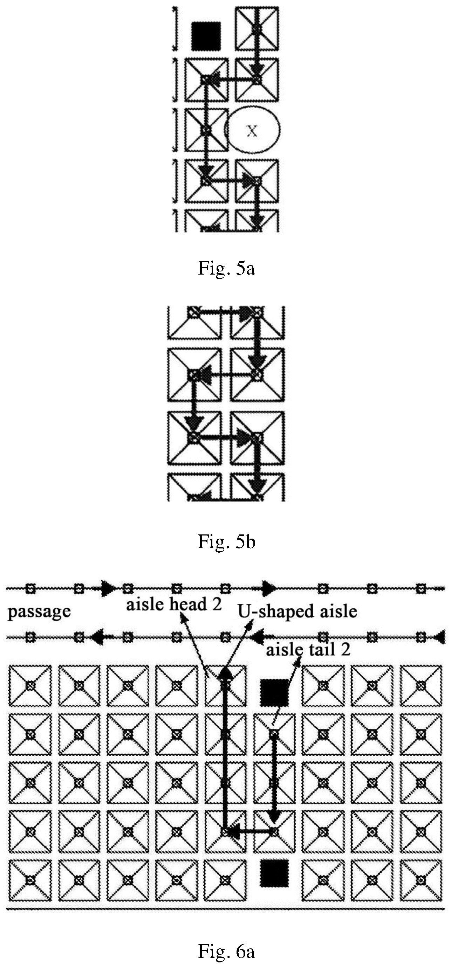

For example, the aisle composed of various storage locations passed by various arrows connecting aisle head 1 and aisle tail 1 in Fig. 4 is a concave-shaped aisle. Among them, as shown in Fig. 5a and Fig. 5b, the concave-shaped aisle in Fig. 4 may be composed of a first concave-shaped aisle segment shown in Fig. 5a and a second concave-shaped aisle segment shown in Fig. 5b. For the concave-shaped aisle in Fig. 4, a person or mobile robot may start from aisle head 1, follow the arrow direction, sequentially pass through each storage location in the obstacle area and the leftmost column of storage locations in the storage area 2 (i.e., the target adjacent storage locations), and move to the aisle tail 1; correspondingly, a person or mobile robot may start from the aisle tail 1, follow the direction opposite to the arrow direction, sequentially pass through each storage location in the obstacle area and the leftmost column of storage locations in the storage area 2, and move to the aisle head 1.

For example, a U-shaped aisle may be as shown in Fig. 6a. The aisle composed of various storage locations passed by various arrows connecting the aisle head 2 and aisle tail 2 in Fig. 6a is the U-shaped aisle. For the U-shaped aisle in Fig. 6a, in this U-shaped aisle, storage locations in the same column as the aisle tail 2 are storage locations in the obstacle area, and storage locations in the same column as the aisle head 2 are target adjacent storage locations. Thus, a person or mobile robot may start from the aisle head 2, follow the direction opposite to the arrow direction, sequentially pass through the target adjacent storage locations and each storage location in the obstacle area, and move to the aisle tail 2; correspondingly, a person or mobile robot may start from the aisle tail 2, follow the arrow direction, sequentially pass through each storage location in the obstacle area and the target adjacent storage locations, and move to the aisle head 2.

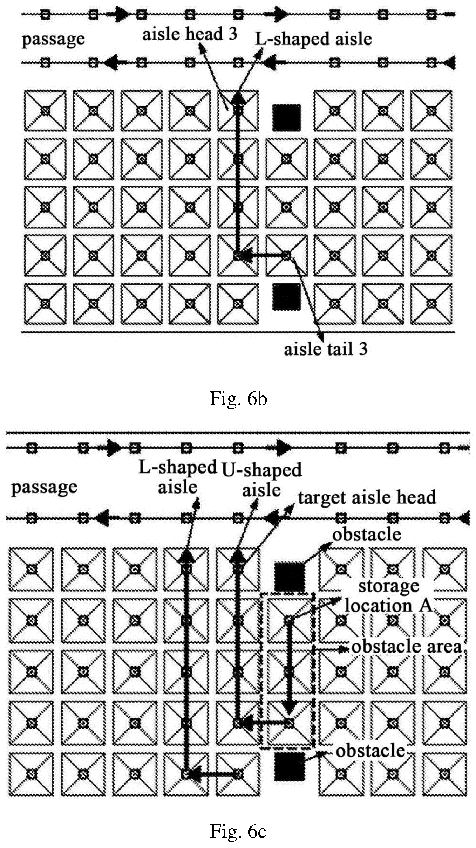

For example, an L-shaped aisle may be as shown in Fig. 6b. The aisle composed of various storage locations passed by various arrows connecting the aisle head 3 and the aisle tail 3 in Fig. 6b is the L-shaped aisle. For the L-shaped aisle in Fig. 6b, in this L-shaped aisle, storage locations in the same column as the aisle tail 3 are storage locations in the obstacle area, and storage locations in the same column as the aisle head 3 are target adjacent storage locations. Thus, a person or mobile robot may start from the aisle head 3, follow the direction opposite to the arrow direction, sequentially pass through the target adjacent storage locations and each storage location in the obstacle area, and move to the aisle tail 3; correspondingly, a person or mobile robot may start from the aisle tail 3, follow the arrow direction, sequentially pass through each storage location in the obstacle area and the target adjacent storage locations, and move to the aisle head 3.

In summary, in the above step S303, performing aisle layout on the target adjacent storage locations of the obstacle area and at least one storage location in the obstacle area is: performing aisle layout on at least one storage location in the target adjacent storage locations of the obstacle area and at least one storage location in the obstacle area.

That is, for each obstacle area, the laid-out first-type aisle includes: at least one storage location in the target adjacent storage locations of the obstacle area and at least one storage location in the obstacle area. For the obstacle area, the laid-out first-type aisle may include all storage locations in the obstacle area, or only part of the storage locations in the obstacle area.

In addition, it can be seen from Fig. 4, Fig. 6a, and Fig. 6b that when the shape of the first-type aisle is concave, both the aisle head and aisle tail of the aisle can be adjacent to a passage; when the shape of the first-type aisle is L-shaped or U-shaped, the aisle tail of the aisle may not be adjacent to a passage. The first-in first-out rule for picking and placing goods requires that both the aisle head and aisle tail of each aisle be adjacent to a passage, and the first-in last-out rule for picking and placing goods requires that the aisle head of each aisle be adjacent to a passage. Therefore, considering the different requirements of different rule for picking and placing goods on whether the aisle head and aisle tail in the aisle are adjacent to the passage, different shape of aisle may be selected for the first-type aisle layout according to different rule for picking and placing goods.

Wherein, for the first-in first-out rule for picking and placing goods, a concave-shaped aisle is selected for the first-type aisle layout; and for the first-in last-out rule for picking and placing goods, a U-shaped and/or L-shaped aisle is selected for the first-type aisle layout.

Optionally, in a specific implementation, the above step S303 may include the following steps 11-12.

Step 11: when the rule for picking and placing goods is first-in first-out, for each obstacle area, performing aisle layout on the target adjacent storage locations of the obstacle area and each storage location in the obstacle area according to an aisle layout rule of a first-type shape, to obtain the laid-out first-type aisle.

Wherein, the first-type shape includes: a concave shape.

In this specific implementation, when the rule for picking and placing goods is the first-in first-out rule, it is usually required to pick up goods from an aisle in the order in which the goods were placed in the aisle. Moreover, for each aisle, when placing goods in the aisle, it is usually necessary to reach the aisle head of the aisle through the passage, then enter the aisle from the aisle head, and place goods in the aisle in the order from the aisle tail to the aisle head; when picking up goods from the aisle, it is usually necessary to reach the aisle tail of the aisle through the passage, then enter the aisle from the aisle tail, and pick up goods from the aisle in the order from the aisle tail to the aisle head. Therefore, when the rule for picking and placing goods is the first-in first-out rule, it is usually required that two storage locations which act as the aisle head and aisle tail of each aisle be adjacent to a passage.

It can be seen from Fig. 4, Fig. 6a, and Fig. 6b that when the shape of the first-type aisle is concave, both the aisle head and aisle tail of the aisle can be adjacent to a passage; when the shape of the first-type aisle is L-shaped or U-shaped, the aisle tail of the aisle may not be adjacent to the passage. Thus, when the rule for picking and placing goods is first-in first-out, for each obstacle area, aisle layout may be performed on the target adjacent storage locations of the obstacle area and each storage location in the obstacle area according to the concave-shaped aisle layout rule, to obtain the laid-out first-type aisle.

That is, the first-in first-out rule for picking and placing goods requires that both the aisle head and aisle tail of each aisle be adjacent to a passage, and the aisle head and aisle tail of the concave-shaped aisle can be storage locations in the storage area adjacent to the passage, respectively. Therefore, to meet the requirements of the above first-in first-out rule for picking and placing goods, the aisle shape used in the aisle layout is the concave shape, and the aisle head and aisle tail of the laid-out concave-shaped aisle are storage locations adjacent to the passage among the target adjacent storage locations of the obstacle area, respectively.

Optionally, in a specific implementation, in the above step 11, performing aisle layout on the target adjacent storage locations of the obstacle area and each storage location in the obstacle area according to an aisle layout rule of a first-type shape, to obtain the laid-out first-type aisle, may include the following steps 21-23.

Step 21: determining any storage location, among the target adjacent storage locations of the obstacle area, that is adjacent to the passage position as a target aisle head.

Step 22: determining a storage location, among the target adjacent storage locations, that is adjacent to the passage position other than the target aisle head as a target aisle tail.

Step 23: determining, from among the target adjacent storage locations and each storage location in the obstacle area, each of target storage locations connecting the target aisle head and the target aisle tail and satisfying the rule for picking and placing goods, to obtain the laid-out first-type aisle of the concave shape.

Wherein, the target storage locations include at least one storage location in the obstacle area.

In this specific implementation, when the rule for picking and placing goods is first-in first-out, according to the concave-shaped aisle layout rule, aisle layout is performed for each obstacle area to obtain a concave-shaped first-type aisle.

Wherein, for each obstacle area, when performing aisle layout on the target adjacent storage locations of the obstacle area and each storage location in the obstacle area according to an aisle layout rule of a first-type shape, any storage location adjacent to the passage position among the target adjacent storage locations of the obstacle area may be first determined as the target aisle head; then, a storage location adjacent to the passage position other than the target aisle head among the target adjacent storage locations is determined as the target aisle tail; finally, each target storage location connecting the target aisle head and the target aisle tail and satisfying the rule for picking and placing goods may be determined among the target adjacent storage locations and each storage location in the obstacle area, to obtain the laid-out first-type aisle of the concave shape.

That is to say, for each obstacle area, first determining storage locations adjacent to the passage among the target adjacent storage locations of the obstacle area; then, selecting one storage location from the above storage locations adjacent to the passage as the target aisle head, and selecting one storage location from the remaining storage locations adjacent to the passage as the target aisle tail. Wherein, considering that there are usually two storage locations adjacent to the passage in the target adjacent storage locations of the obstacle area, the two storage locations adjacent to the passage may be used as the target aisle head and target aisle tail, respectively. Wherein, the target aisle head and target aisle tail belong to the same laid-out first-type aisle.

For each obstacle area, after determining the above target aisle head and target aisle tail, a storage location adjacent to the target aisle head may be first selected from storage locations in the obstacle area and the target adjacent storage locations other than the above target aisle head and target aisle tail, as the first target storage location; then, starting from the first target storage location, sequentially select a target storage location adjacent to the previous target storage location from the unselected storage locations in the obstacle area and the target adjacent storage locations, until the last target storage location adjacent to the target aisle tail is selected, so that the above target aisle head, the selected target storage locations, and the target aisle tail constitute the laid-out first-type aisle of the concave shape.

Wherein, in the above aisle layout process, two adjacent storage locations are located in the same row or same column.

For example, as shown in Fig. 4, after determining the leftmost column of storage locations in storage area 2 as the target adjacent storage locations of the obstacle area, the topmost storage location in the target adjacent storage locations may be used as the target aisle head, that is, aisle head 1 is used as the target aisle head, and the bottommost storage location in the target adjacent storage locations may be used as the target aisle tail, that is, aisle tail 1 is used as the target aisle tail. Then, first, in the target adjacent storage locations, select the adjacent storage location below the aisle head 1 as the first target storage location; then, in the obstacle area, select the adjacent storage location to the left of the first target storage location as the second target storage location; then, in the obstacle area, select the adjacent storage location below the second target storage location as the third target adjacent storage location. In this way, selections are made sequentially until the adjacent storage location above the aisle tail 1 in the target adjacent storage locations is selected as the last target storage location, then the aisle head 1, the 13 selected target storage locations, and the aisle tail 1 constitute the laid-out first-type aisle of the concave shape.

Optionally, passages in the warehouse area to be laid out may include a goods placing passage and a goods picking passage, and when the rule for picking and placing goods is the first-in first-out rule, for each aisle, when placing goods in the aisle, it is usually necessary to reach the aisle head through the goods placing passage, then enter the aisle from the aisle head, and place goods in the aisle in the order from the aisle tail to the aisle head; when picking up goods from the aisle, it is usually necessary to reach the aisle tail through the goods picking passage, then enter the aisle from the aisle tail, and pick up goods from the aisle in the order from the aisle tail to the aisle head.

Thus, when the rule for picking and placing goods is the first-in first-out rule and the above passages include a goods placing passage and a goods picking passage, for each obstacle area, when determining the target aisle head and target aisle tail, a storage location located at the edge of the adjacent storage area and adjacent to the goods placing passage among the target adjacent storage locations of the obstacle area may be determined as the target aisle head; and a storage location other than the target aisle head, located at the edge of the adjacent storage area and adjacent to the goods picking passage among the target adjacent storage locations, may be determined as the target aisle tail belonging to the same aisle as the target aisle head.

For example, as shown in Fig. 4, for the obstacle area in Fig. 4, the target adjacent storage locations of the obstacle area may be a column of storage locations in storage area 2 adjacent to the obstacle area. That is, for the obstacle area in Fig. 4, the target adjacent storage locations of the obstacle area may be the leftmost column of storage locations in storage area 2. Then, when determining the target aisle head and target aisle tail, a storage location located at the edge of storage area 2 and adjacent to the goods placing passage among one column of storage locations in storage area 2 adjacent to the obstacle area, that is, aisle head 1, may be determined as the target aisle head; a storage location other the aisle head 1, located at the edge of storage area 2 and adjacent to the goods picking passage among one column of storage locations in storage area 2 adjacent to the obstacle area, that is, aisle tail 1, may be determined as the target aisle tail belonging to the same aisle as the aisle head 1.

Furthermore, according to the concave-shaped aisle layout rule, the first concave-shaped aisle segment shown in Fig. 5a and the second concave-shaped aisle segment shown in Fig. 5b may be superimposed and combined, so as to determine each target storage location connecting the target aisle head and target aisle tail and satisfying the rule for picking and placing goods among the target adjacent storage locations and each storage location in the obstacle area, to obtain the laid-out first-type aisle.

According to Fig. 5a, it can be seen that when determining the first-type aisle according to the concave-shaped aisle layout rule, each time one first concave-shaped aisle segment is combined, one storage location at the position indicated by the letter x will be lost; according to Fig. 5b, it can be seen that when determining the first-type aisle according to the concave-shaped aisle layout rule, combining the second concave-shaped aisle segment will not lose a storage location. Then, when determining the first-type aisle according to the concave-shaped aisle layout rule, to improve storage location utilization, the second concave-shaped aisle segments may be superimposed and combined as much as possible.

For example, for the obstacle area in Fig. 4, as shown in Fig. 4, storage location 1 is an unused lost storage location. As shown in Fig. 4, after determining aisle head 1 and aisle tail 1 belonging to the same aisle, the first-type aisle corresponding to aisle head 1 and aisle tail 1 laid out according to the concave-shaped aisle layout rule may be composed of various storage locations passed by various arrow connecting the aisle head 1 and aisle tail 1 in Fig. 4, and the direction indicated by each arrow may be used to indicate the sequence of picking and placing goods in the first-type aisle. It can be seen that when determining the first-type aisle corresponding to aisle head 1 and aisle tail 1 according to the concave-shaped aisle layout rule, storage location 1 is lost.

Wherein, when picking and placing goods in the concave-shaped aisle shown in Fig. 4, goods are picked and placed in the concave-shaped aisle in the order opposite to the direction indicated by each arrow. That is, when placing goods, goods are first placed in aisle tail 1, and finally in aisle head 1; when picking up goods, the goods placed in aisle tail 1 are picked up first, and finally the goods placed in aisle head 1 are picked up.

Step 12: when the rule for picking and placing goods is first-in last-out, for each obstacle area, performing aisle layout on the target adjacent storage locations of the obstacle area and each storage location in the obstacle area according to an aisle layout rule of a second-type shape, to obtain the laid-out first-type aisle.

Wherein, the second-type shape includes: a U shape, and/or, an L shape.

In this specific implementation, when the rule for picking and placing goods is the first-in last-out rule, it is usually required to pick up goods from the aisle in the reverse order in which the goods were placed in the aisle. Moreover, for each aisle, when placing goods in the aisle, it is usually necessary to reach the aisle head of the aisle through a passage, then enter the aisle from the aisle head, and place goods in the aisle in the order from the aisle tail to the aisle head; when picking up goods from the aisle, it is usually necessary to reach the aisle head of the aisle through a passage, then enter the aisle from the aisle head, and pick up goods from the aisle in the order from the aisle head to the aisle tail. Therefore, when the rule for picking and placing goods is the first-in last-out rule, it is usually required that a storage location acting the aisle head of each aisle be adjacent to a passage.

While, according to the aisles shown in Fig. 6a and Fig. 6b, and the above description of the concave-shaped first-type aisle, when the rule for picking and placing goods is first-in last-out, for each obstacle area, aisle layout may be performed on the target adjacent storage locations of the obstacle area and each storage location in the obstacle area according to the U-shaped and/or L-shaped aisle layout rule, to obtain the laid-out first-type aisle, then when the rule for picking and placing goods is first-in last-out, the laid-out first-type aisle is a U-shaped aisle, or an L-shaped aisle.

That is to say, the first-in last-out rule for picking and placing goods requires that an aisle head of each aisle be adjacent to a passage, and an aisle head of the U-shaped aisle or L-shaped aisle can be a storage location in the storage area adjacent to a passage. Therefore, to meet the requirements of the above first-in last-out rule for picking and placing goods, the aisle shape used in the aisle layout may be a U-shaped aisle, or an L-shaped aisle, or part U-shaped aisles and part L-shaped aisles. Moreover, the aisle head of the laid-out U-shaped aisle and/or L-shaped aisle is a storage location adjacent to a passage among the target adjacent storage locations of the obstacle area, and to make the laid-out first-type aisle contain a storage location in the obstacle area, the aisle tail of the laid-out U-shaped aisle and/or L-shaped aisle is a storage location in the obstacle area.

Optionally, in a specific implementation, in the above step 12, performing aisle layout on the target adjacent storage locations of the obstacle area and each storage location in the obstacle area according to an aisle layout rule of a second-type shape, to obtain the laid-out first-type aisle, may include the following steps 31-33.

Step 31: determining any storage location, among the target adjacent storage locations of the obstacle area, that is adjacent to the passage position as a target aisle head.

Step 32: determining any storage location among storage locations in the obstacle area as a target aisle tail.

In this specific implementation, when the rule for picking and placing goods is first-in last-out, according to the U-shaped or L-shaped aisle layout rule, aisle layout is performed for each obstacle area to obtain a U-shaped first-type aisle or an L-shaped first-type aisle.

Wherein, for each obstacle area, when performing aisle layout on the target adjacent storage locations of the obstacle area and each storage location in the obstacle area according to an aisle layout rule of a second-type shape, any storage location adjacent to the passage position among the target adjacent storage locations of the obstacle area may be determined as the target aisle head; then, any storage location among storage locations in the obstacle area is determined as the target aisle tail. The target aisle head and target aisle tail belong to the same laid-out first-type aisle.

Optionally, in a specific implementation, the above step 32, determining any storage location among storage locations in the obstacle area as the target aisle tail, may include the following step 41.

Step 41: determining, from among the storage locations in the obstacle area, a storage location that is adjacent to an obstacle in the obstacle area and is closest to the target aisle head as the target aisle tail.

Wherein, the shape of the obtained first-type aisle is the U shape.

In this specific implementation, for each obstacle area, when performing aisle layout on the target adjacent storage locations of the obstacle area and each storage location in the obstacle area according to the U-shaped aisle layout rule, any storage location adjacent to the passage position among the target adjacent storage locations of the obstacle area may be determined as the target aisle head; a storage location adjacent to an obstacle in the obstacle area and closest to the target aisle head among each storage location in the obstacle area is determined as the target aisle tail.

For example, as shown in Fig. 6c, for the obstacle area in Fig. 6c, when laying out the first-type aisle according to the U-shaped aisle layout rule, first, one column of storage locations in the adjacent storage area on the left side of the obstacle area, which are adjacent to the obstacle area and arranged in the arrangement direction of storage locations in the obstacle area, may be determined as the target adjacent storage locations of the obstacle area, that is, the rightmost column of storage locations in the adjacent storage area on the left side of the obstacle area may be used as the target adjacent storage locations of the obstacle area; then, among the target adjacent storage locations of the obstacle area, a storage location that is at the topmost and adjacent to the passage position is determined as the target aisle head, and among storage locations in the obstacle area, a storage location A that is adjacent to an obstacle in the obstacle area and closest to the target aisle head is determined as the target aisle tail. As shown in Fig. 6c, among storage locations in the obstacle area, there are two storage locations adjacent to obstacles, and storage location A among the two storage locations is not only adjacent to an obstacle but also closest to the target aisle head, so storage location A is determined as the target aisle tail.

However, when the quantity of storage locations in the obstacle area is large, applying this specific implementation to determine the target aisle tail may result in too many storage locations of the laid-out first-type aisle are located in the obstacle area, thereby making the efficiency of picking and placing goods in this first-type aisle low and unable to meet the efficiency requirements of goods picking and placing.

Therefore, optionally, in a specific implementation, the above step 41 may include the following step 51.

Step 51: if the quantity of storage locations in the obstacle area is less than or equal to a designated quantity, determining, from among the storage locations in the obstacle area, a storage location that is adjacent to an obstacle in the obstacle area and is closest to the target aisle head as the target aisle tail.

In this specific implementation, a person skilled in the art may determine the above designated quantity according to the efficiency requirements of goods picking and placing. If the quantity of storage locations in the obstacle area is less than or equal to the above designated quantity, a storage location adjacent to an obstacle in the obstacle area and closest to the target aisle head among storage locations in the obstacle area may be directly determined as the target aisle tail.

Corresponding to the above step 51, in this specific implementation, the aisle layout method provided by an embodiment of the present application may further include the following step 52.

Step 52: if the quantity of storage locations in the obstacle area is greater than the designated quantity, determining, from among the storage locations in the obstacle area, a storage location spaced from an obstacle closest to the target aisle head by a target quantity of storage locations as the target aisle tail.

Wherein, the target quantity is: a difference between the quantity of storage locations and the designated quantity, and the shape of the obtained first-type aisle is the U shape, or, the L shape.

When the quantity of storage locations in the obstacle area is greater than the designated quantity, if a storage location adjacent to an obstacle in the obstacle area and closest to the target aisle head among storage locations in the obstacle area is determined as the target aisle tail, the quantity of storage locations of the laid-out first-type aisle in the obstacle area will be greater than the designated quantity, which may cause the goods picking and placing efficiency of the laid-out first-type aisle to fail to meet the efficiency requirements of goods picking and placing. Therefore, in this case, the difference between the quantity of storage locations in the obstacle area and the designated quantity may be determined as the target quantity, and a storage location spaced from an obstacle closest to the target aisle head by the target quantity of storage locations among storage locations in the obstacle area may be determined as the target aisle tail.

That is to say, when the quantity of storage locations in the obstacle area is greater than the designated quantity, first calculate the difference between the quantity of storage locations in the obstacle area and the designated quantity to obtain the target quantity; then, in the obstacle area, determine a storage location adjacent to an obstacle in the obstacle area and closest to the target aisle head; then, determine a storage location spaced from the above closest storage location by the target quantity of storage locations, and this finally determined storage location is the target aisle tail.

Wherein, assuming that the quantity of storage locations in the obstacle area is M, the designated quantity is N, and M > N, then the target quantity is M-N; if starting from a storage location in the obstacle area that is adjacent to an obstacle in the obstacle area and closest to the target aisle head, sequentially number each storage location in the obstacle area, with the starting number being 1, and the number difference between adjacent storage locations being 1, then the number of the storage location in the obstacle area that is adjacent to an obstacle in the obstacle area and closest to the target aisle head is 1, and then the number of a storage location spaced from the storage location with number 1 by the above target quantity (M-N) is: 1 + (M-N) + 1, that is, the number of the storage location finally determined as the target aisle tail is 2 + M - N.

For example, as shown in Fig. 6b, assume that the quantity of storage locations in the obstacle area M=3, the designated quantity N=2, since 3 > 2, there is a target quantity M-N=3-2=1; the storage locations in the same column as aisle tail 3 are the storage locations in the obstacle area, and in the order from top to bottom, the numbers of storage locations in the obstacle area are 1, 2, and 3, respectively. Then the number of the storage location finally determined as the target aisle tail is: 2 + M - N = 2 + 3 - 2 = 3, that is, the storage location with number 3 in the obstacle area is determined as the target aisle tail, that is, aisle tail 3 in Fig. 6b is determined as the target aisle tail. At this time, the laid-out first-type aisle is an L-shaped aisle.

Wherein, among storage locations in the obstacle area, if a storage location that is spaced from an obstacle closest to the target aisle head by the target quantity of storage locations is the storage location that is adjacent to an obstacle in the obstacle area and farthest from the target aisle head, then the shape of the finally obtained first-type aisle is the L shape.

That is to say, among storage locations in the obstacle area, if the storage location determined as the target aisle tail is: the storage location that is adjacent to an obstacle in the obstacle area and farthest from the target aisle head, then the finally laid-out first-type aisle is an L-shaped aisle, for example, the L-shaped aisle shown in Fig. 6b.

Among storage locations in the obstacle area, if the storage location that is spaced from an obstacle closest to the target aisle head by the target quantity of storage locations is not the storage location that is adjacent to an obstacle in the obstacle area and farthest from the target aisle head, then the shape of the finally obtained first-type aisle is the U shape.

That is to say, among storage locations in the obstacle area, if the storage location determined as the target aisle tail is not the storage location that is adjacent to an obstacle in the obstacle area and farthest from the target aisle head, then the finally laid-out first-type aisle is a U-shaped aisle.

Based on this, by applying this specific implementation, when the quantity of storage locations in the obstacle area is large, it can be avoided that there are too many storage locations of the laid-out first aisle are located in the obstacle area, so that the goods picking and placing efficiency of the laid-out first-type aisle can meet the efficiency requirements of goods picking and placing.

Optionally, in a specific implementation, the above step 32, determining any storage location among storage locations in the obstacle area as the target aisle tail, may include the following step 42.

Step 42: determining, from among the storage locations in the obstacle area, a storage location that is adjacent to an obstacle in the obstacle area and is farthest from the target aisle head as the target aisle tail.

Wherein, the shape of the obtained first-type aisle is the L shape.

In this specific implementation, for each obstacle area, when performing aisle layout on the target adjacent storage locations of the obstacle area and each storage location in the obstacle area according to the L-shaped aisle layout rule, any storage location adjacent to the passage position among the target adjacent storage locations of the obstacle area may be determined as the target aisle head; a storage location adjacent to an obstacle in the obstacle area and farthest from the target aisle head among storage locations in the obstacle area is determined as the target aisle tail.

For example, as shown in Fig. 6b, an area where storage locations in the same column as aisle tail 3 are located is an obstacle area, and the storage locations in the same column as aisle tail 3 are storage locations in the obstacle area. Thus, for the obstacle area in Fig. 6b, when laying out the first-type aisle according to the L-shaped aisle layout rule, first, one column of storage locations adjacent to the obstacle area on the left side may be determined as the target adjacent storage locations of the obstacle area; then, among the target adjacent storage locations of the obstacle area, a storage location that is at the topmost and adjacent to the passage position is determined as the target aisle head, that is, aisle head 3 is determined as the target aisle head, and among the storage locations in the obstacle area, a storage location that is adjacent to an obstacle in the obstacle area and is farthest from the target aisle head is determined as the target aisle tail, that is, aisle tail 3 is determined as the target aisle tail. As shown in Fig. 6b, among the storage locations in the obstacle area, there are two storage locations adjacent to obstacles, and aisle tail 3 among the two storage locations is not only adjacent to an obstacle but also farthest from the target aisle head, so aisle tail 3 is determined as the target aisle tail.

Step 33: determining, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or an L shape.

Wherein, the target storage locations include: all storage locations in the designated direction; the designated direction is: a direction from the target aisle tail pointing to an obstacle in the obstacle area that is farthest from the target aisle head.

For each obstacle area, after determining the above target aisle head and target aisle tail, the designated direction may be determined first. Wherein, the designated direction may be a direction from the target aisle tail pointing to an obstacle in the obstacle area that is farthest from the target aisle head, so that the target storage locations may include all storage locations in the obstacle area in the above designated direction starting from the target aisle tail, and part or all of the storage locations in the target adjacent storage locations. Thus, after determining the target aisle head and target aisle tail, each target storage location connecting the target aisle head and the target aisle tail and satisfying the rule for picking and placing goods may be determined among the target adjacent storage locations, and storage locations in the obstacle area in the designated direction starting from the target aisle tail, to obtain the laid-out first-type aisle of the U shape or the L shape.

For example, as shown in Fig. 6c, for the obstacle area in Fig. 6c, when laying out the first-type aisle according to an aisle layout rule of a second-type shape, first, the rightmost column of storage locations in the adjacent storage area on the left side of the obstacle area may be used as the target adjacent storage locations of the obstacle area; then, among the target adjacent storage locations of the obstacle area, a storage location that is at the topmost and adjacent to the passage position is determined as the target aisle head, and among storage locations in the obstacle area, a storage location A that is adjacent to an obstacle in the obstacle area and closest to the target aisle head is determined as the target aisle tail. An obstacle in the obstacle area that is farthest from the target aisle head is an obstacle below storage location A, so the designated direction is the direction from storage location A pointing to the obstacle below storage location A, that is, the designated direction is the downward direction. Thus, the target storage locations may include all storage locations below storage location A in the obstacle area, and the first storage location, the second storage location, and the third storage location below the target aisle head in the target adjacent storage locations. Thus, the above each target storage location can connect the target aisle head and storage location A as the target aisle tail, thereby obtaining the U-shaped aisle as shown in Fig. 6c, as the laid-out first-type aisle.

Optionally, in a specific implementation, the aisle layout method provided by an embodiment of the present application may further include the following step 61.

Step 61: performing, for each storage area, aisle division on each storage location in the storage area that has not been determined as a target storage location based on the rule for picking and placing goods and the passage position, to obtain each laid-out second-type aisle.

In this specific implementation, after laying out each first-type aisle corresponding to each obstacle area, there may still be some storage locations in the storage area that have not been determined as target storage locations. Therefore, for each storage area, aisle division may be performed on each storage location in the storage area that has not been determined as a target storage location based on the rule for picking and placing goods and the passage position, thereby obtaining each laid-out second-type aisle.

That is, after laying out the first-type aisle for each obstacle area, there may still be some storage locations in the storage area that have not been laid out into any aisle. Therefore, for each storage area, aisle division may be performed on each storage location in the storage area that has not been laid out into any aisle based on the rule for picking and placing goods and the passage position, thereby obtaining each laid-out second-type aisle.

Optionally, in a specific implementation, the rule for picking and placing goods may be first-in first-out; the above step 61 may include the following steps 71-72.

Step 71: for each storage area, in response to determining that the storage area contains any of the target adjacent storage locations, dividing storage locations in the storage area into multiple groups of storage locations according to the arrangement direction; and dividing each group of storage locations that does not contain any of the target adjacent storage locations as a same aisle, to obtain each laid-out second-type aisle.

Step 72: for each storage area, in response to determining that the storage area does not contain any of the target adjacent storage locations, dividing storage locations in the storage area into multiple groups of storage locations according to the arrangement direction; and divide each group of storage locations into a same aisle, to obtain each laid-out second-type aisle.

In this specific implementation, when the rule for picking and placing goods is the first-in first-out rule, for each storage area, if the storage area contains any of the target adjacent storage locations, storage locations in the storage area can be divided into multiple groups of storage locations according to the arrangement direction, and each group of storage locations that does not contain any of the target adjacent storage locations is divided as the same aisle, thereby obtaining each laid-out second-type aisle.

Herein, the aforementioned target adjacent storage locations refer to the target adjacent storage locations of the obstacle area. That is to say, when the rule for picking and placing goods is the first-in first-out rule, for each storage area, if the storage area contains any of the target adjacent storage locations of the obstacle area, for storage positions in the storage area that have not been laid-out in any aisle, the storage positions that have not been laid-out in any aisle in the storage area may be first divided into multiple groups of storage positions according to the arrangement direction of the storage positions in the obstacle area, and for each group of storage locations obtained by division, if the group of storage locations does not contain any of the target adjacent storage locations of any obstacle area, the group of storage locations may be divided as the same aisle. Since the target adjacent storage locations of the obstacle area are usually adjacent to the obstacle area on the designated side, for each group of storage locations obtained by division, if this group of storage locations is located on the designated side of a certain obstacle area and adjacent to the obstacle area, this group of storage locations cannot be laid out as a second-type aisle; on the contrary, if this group of storage locations is not adjacent to any obstacle area, or is adjacent to a certain obstacle area but not on the designated side of the obstacle area, this group of storage locations is divided as the same aisle, thereby being laid out as a second-type aisle.

For example, by applying this specific implementation to perform aisle division on each storage location in storage area 2 in Fig. 4 that has not been determined as a target storage location, the 5 second-type aisles indicated by labels a-e in Fig. 4 can be obtained.

Correspondingly, if the storage area does not contain the target adjacent storage locations of any obstacle area, storage locations in the storage area are divided into multiple groups of storage locations according to the arrangement direction of storage locations in the obstacle area; and each group of storage locations is divided as a same aisle, thereby obtaining each laid-out second-type aisle.

Optionally, in a specific implementation, the rule for picking and placing goods may be first-in last-out, and there is an idle storage location among the target adjacent storage locations that has not been divided into the target storage location; the above step 61 may include the following steps 81-82.

Step 81: for each storage area, in response to determining that the storage area contains any of the target adjacent storage locations, dividing storage locations in the storage area into multiple groups of storage locations according to the arrangement direction; dividing the idle storage location and a group of storage locations adjacent to the idle storage location as a same L-shaped aisle, and dividing each group of storage locations that does not contain any of the target adjacent storage locations as a same aisle, to obtain each laid-out second-type aisle.

In this specific implementation, when the rule for picking and placing goods is the first-in last-out rule, for each storage area, if the storage area contains any of the target adjacent storage locations, and there is an idle storage location among the target adjacent storage locations that has not been divided into the target storage location, storage locations in the storage area may be divided into multiple groups of storage locations according to the arrangement direction; the idle storage location and a group of storage locations adjacent to the idle storage location are divided as a same L-shaped aisle, and each group of storage locations that does not contain any of the target adjacent storage locations is divided as a same aisle, thereby obtaining each laid-out second-type aisle.

Herein, the above target adjacent storage locations refer to: the target adjacent storage locations of the obstacle area. The idle storage location among the target adjacent storage locations that has not been divided as the target storage locations refers to: a storage location among the target adjacent storage locations of the obstacle area that has not been laid out into the first-type aisle when laying out the first-type aisle for the obstacle area.

For example, as shown in Fig. 6c, a left adjacent storage location of an obstacle below storage location A is a storage location among the target adjacent storage locations of the obstacle area that has not been laid out into the first-type aisle (the U-shaped aisle in Fig. 6c), that is, the left adjacent storage location of the obstacle below storage location A is an idle storage location among the target adjacent storage locations that has not been divided as the target storage location. Based on this, by dividing the idle storage location and a group of storage locations adjacent to the idle storage location as a same L-shaped aisle, the obtained second-type aisle may be the L-shaped aisle as shown in Fig. 6c.

Optionally, in a specific implementation, the above arrangement direction may be a direction perpendicular to the passage, and dividing into multiple groups of storage locations according to the arrangement direction may be dividing each column of storage locations arranged perpendicular to the passage as a group of storage locations.

Step 82: for each storage area, in response to determining that the storage area does not contain any of the target adjacent storage locations, dividing storage locations in the storage area into multiple groups of storage locations according to the arrangement direction; and dividing each group of storage locations as a same aisle, to obtain each laid-out second-type aisle.

For each storage area, if the storage area does not contain the target adjacent storage locations, storage locations in the storage area may be divided into multiple groups of storage locations according to the arrangement direction; and each group of storage locations is divided as a same aisle, thereby obtaining each laid-out second-type aisle.

Based on this, by applying the solution provided in the embodiments of the present application, when performing aisle layout on a warehouse area to be laid out, storage locations in the obstacle area can be laid out into an aisle by using a storage location in a storage area adjacent to the obstacle area, so that the obstacle area can also store goods, thereby improving the utilization of the storage space of the warehouse.

That is, by applying the solution provided in the embodiments of the present application, when performing aisle layout on a warehouse area to be laid out, a storage location located in an obstacle area between two obstacles and not belonging to any storage area can be determined, and further the storage location located in an obstacle area between two obstacles and not belonging to any storage area can be laid out into an aisle in the aforementioned warehouse area, so that the obstacle area can also be used for storing goods, thereby improving the utilization of the storage space of the warehouse.

In addition, in some cases, the electronic device may implement the above aisle layout method by responding to control instructions from staff. For example, the process of the electronic device implementing the above aisle layout method by responding to control instructions from staff is as follows:
Step 1: staff may send an information acquisition instruction about the warehouse area to be laid out to the electronic device. The electronic device may receive the information acquisition instruction and, in response to the information acquisition instruction, acquire and display area distribution information and a rule for picking and placing goods of the warehouse area to be laid out, so that the user can view the area distribution information and the rule for picking and placing goods of the warehouse area to be laid out.
Step 2: when the staff view the area distribution information of the warehouse area to be laid out, the staff may set the storage location size and the distance between every two adjacent storage locations according to their own needs, and then send a storage location division instruction including the storage location size and the distance between every two adjacent storage locations to the electronic device.

The electronic device may receive the storage location division instruction and, in respond to the storage location division instruction, determine each storage location located in the storage area and each storage location located in an obstacle area between two obstacles and not belonging to any storage area according to the storage area position and the obstacle position, thereby obtaining each storage location in the warehouse area to be laid out. Furthermore, the electronic device may superimpose and display the determined each storage location in the displayed area distribution information of the warehouse area to be laid out.

Step 3: when the staff view each storage location superimposed and displayed in the area distribution information of the warehouse area to be laid out, staff may, for each obstacle area, determine a target aisle head among the target adjacent storage locations of the obstacle area based on the rule for picking and placing goods and the passage position, and determine, from among the target adjacent storage locations other than the target aisle head and each storage location in the obstacle area, a target aisle tail belonging to the same aisle as the target aisle head, and determine each target storage location belonging to the same aisle as the target aisle head and target aisle tail and satisfying the rule for picking and placing goods among the target adjacent storage locations and each storage location in the obstacle area.

Then, the staff may send a first-type aisle division instruction including the above target aisle head, target aisle tail, and each target storage location to the electronic device, so that after receiving the above first-type aisle division instruction, the electronic device may divide the above target aisle head, target aisle tail, and each target storage location as a first-type aisle and store it.

Step 4: after laying out the first-type aisle, staff may further perform aisle division on each storage location in the storage area that has not been determined as a target storage location for each storage area based on the rule for picking and placing goods and the passage position, thereby determining the storage locations included in each second-type aisle.

Then, staff may send a second-type aisle division instruction including the storage locations included in each second-type aisle to the electronic device, so that after receiving the above second-type aisle division instruction, the electronic device may divide and obtain each second-type aisle according to the storage locations included in each second-type aisle and store it.

Based on this, when performing aisle layout on a warehouse area to be laid out, through human-computer interaction, storage locations in the obstacle area can be laid out into an aisle by using storage locations in a storage area adjacent to the obstacle area, so that the obstacle area can also store goods, thereby improving the utilization of the storage space of the warehouse.

Corresponding to the above aisle layout method provided by the embodiments of the present application, an embodiment of the present application further provides an aisle layout apparatus.

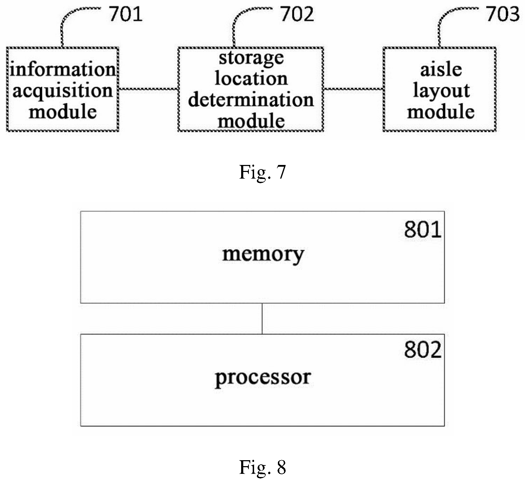

Fig. 7 is a structural diagram of an aisle layout apparatus provided by an embodiment of the present application. As shown in Fig. 7, the aisle layout apparatus may include the following modules:
an information acquisition module 701, configured to acquire area distribution information and a rule for picking and placing goods of a warehouse area to be laid out; wherein the area distribution information includes: a passage position, a storage area position, and an obstacle position;
a storage location determination module 702, configured to determine each storage location located in a storage area and each storage location located in an obstacle area between two obstacles and not belonging to any of storage areas according to the storage area position and the obstacle position;
an aisle layout module 703, configured to, perform for each obstacle area, aisle layout on target adjacent storage locations of the obstacle area and at least one storage location in the obstacle area according to an aisle layout rule matching the rule for picking and placing goods, to obtain a laid-out first-type aisle; wherein the target adjacent storage locations of each obstacle area include: each storage location located in an adjacent storage area on a designated side of the obstacle area, which is adjacent to the obstacle area, and arranged in an arrangement direction of storage locations in the obstacle area; a shape of the first-type aisle includes at least one of a concave shape, an L shape, and a U shape.

It can be seen from the above, by applying the solutions provided in the embodiments of the present application, when performing aisle layout on a warehouse area to be laid out, a storage location located in an obstacle area between two obstacles and not belonging to any storage area can be determined, and further, storage locations in the obstacle area can be laid out into an aisle by using storage locations in a storage area adjacent to the obstacle area, that is, an aisle including the storage location located in the obstacle area between two obstacles and not belonging to any storage area can be laid out in the aforementioned warehouse area, so that the obstacle area can also be used for storing goods, thereby improving the utilization of the storage space of the warehouse.

Optionally, in a specific implementation, the aisle layout module includes:
a first layout sub-module, configured to, when the rule for picking and placing goods is first-in first-out, for each obstacle area, perform aisle layout on the target adjacent storage locations of the obstacle area and each storage location in the obstacle area according to an aisle layout rule of a first-type shape, to obtain the laid-out first-type aisle; wherein the first-type shape includes: a concave shape;
a second layout sub-module, configured to, when the rule for picking and placing goods is first-in last-out, for each obstacle area, perform aisle layout on the target adjacent storage locations of the obstacle area and each storage location in the obstacle area according to an aisle layout rule of a second-type shape, to obtain the laid-out first-type aisle; wherein the second-type shape includes: a U shape, and/or, an L shape.

Optionally, in a specific implementation, the first layout sub-module is specifically configured to:
determine any storage location, among the target adjacent storage locations of the obstacle area, that is adjacent to the passage position as a target aisle head;
determine a storage location, among the target adjacent storage locations, that is adjacent to the passage position other than the target aisle head as a target aisle tail;
determine, from among the target adjacent storage locations and each storage location in the obstacle area, each of target storage locations connecting the target aisle head and the target aisle tail and satisfying the rule for picking and placing goods, to obtain the laid-out first-type aisle of a concave shape; wherein the target storage locations comprise at least one storage location in the obstacle area.

Optionally, in a specific implementation, the second layout sub-module includes:
an aisle head determination unit, configured to determine any storage location, among the target adjacent storage locations of the obstacle area, that is adjacent to the passage position as a target aisle head;
an aisle tail determination unit, configured to determine any storage location among storage locations in the obstacle area as a target aisle tail;
an aisle determination unit, configured to determine, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or an L shape; wherein the target storage locations comprise: all storage locations in the designated direction; the designated direction is: a direction from the target aisle tail pointing to an obstacle in the obstacle area that is farthest from the target aisle head.

Optionally, in a specific implementation, the aisle tail determination unit includes:
a first determination sub-unit, configured to determine, from among the storage locations in the obstacle area, a storage location that is adjacent to an obstacle in the obstacle area and is closest to the target aisle head as the target aisle tail; wherein the shape of the obtained first-type aisle is the U shape;
   or,
a second determination sub-unit, configured to determine, from among the storage locations in the obstacle area, a storage location that is adjacent to an obstacle in the obstacle area and is farthest from the target aisle head as the target aisle tail; wherein the shape of the obtained first-type aisle is the L shape.

Optionally, in a specific implementation, the first determination sub-unit is specifically configured to:
in response to determining that a quantity of storage locations in the obstacle area is less than or equal to a designated quantity, determine, from among the storage locations in the obstacle area, a storage location that is adjacent to an obstacle in the obstacle area and is closest to the target aisle head as the target aisle tail;
the apparatus further includes:
   an aisle tail determination module, configured to, in response to determining that the quantity of storage locations in the obstacle area is greater than the designated quantity, determine, from among the storage locations in the obstacle area, a storage location spaced from an obstacle closest to the target aisle head by a target quantity of storage locations as the target aisle tail; wherein the target quantity is: a difference between the quantity of storage locations and the designated quantity, and the shape of the obtained first-type aisle is the U shape or the L shape.

Optionally, in a specific implementation, the apparatus further includes:
an aisle division module, configured to, for each storage area, perform aisle division on each storage location in the storage area that has not been determined as a target storage location based on the rule for picking and placing goods and the passage position, to obtain each laid-out second-type aisle.

Optionally, in a specific implementation, the rule for picking and placing goods is first-in first-out; the aisle division module is specifically configured to:
for each storage area, in response to determining that the storage area contains any of the target adjacent storage locations, divide storage locations in the storage area into multiple groups of storage locations according to the arrangement direction; and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

Optionally, in a specific implementation, the rule for picking and placing goods is first-in last-out, and there is an idle storage location among the target adjacent storage locations that has not been divided into target storage locations;
the aisle division module is specifically configured to:
for each storage area, in response to determining that the storage area contains any of the target adjacent storage locations, divide storage locations in the storage area into multiple groups of storage locations according to the arrangement direction; divide the idle storage location and a group of storage locations adjacent to the idle storage location as a same L-shaped aisle, and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

An embodiment of the present application further provides an electronic device, as shown in Fig. 8, including:
a memory 801, configured to store a computer program;
a processor 802, configured to execute the program stored in the memory 801 to implement the steps of any one of the aforementioned aisle layout methods.

The electronic device mentioned above can further include a communication bus and/or a communication interface, and the processor 802, communication interface, and the memory 801 communicate with each other via the communication bus.

The communication bus mentioned above in the electronic device can be a Peripheral Component Interconnect (PCI) bus or an Extended Industry Standard Architecture (EISA) bus, etc. The communication bus can be divided into an address bus, a data bus, a control bus and so on. For ease of presentation, only a thick line is shown in the figure, but this does not mean that there is only one bus or one type of bus.

The communication interface is used for communication between the above electronic device and other devices.

The Memory may include a random access memory (RAM) or a non-volatile memory (NVM), such as at least one disk memory. Optionally, the memory may also be at least one storage device located away from the aforementioned processor.

The above processor may be a general-purpose processor, including a central processing unit (CPU), a network processor (NP), etc.; it may also be a digital signal processor (DSP), an application specific integrated circuit (ASIC), a field-programmable gate array (FPGA) or other programmable logic devices, discrete gates or transistor logic devices, discrete hardware components.

In yet another embodiment provided by the present application, a computer-readable storage medium is further provided, which has a computer program stored therein, which when executed by a processor, carries out the steps of any one of the aisle layout methods mentioned above.

In yet another embodiment provided by the present application, a computer program product containing instructions is also provided, which when run on a computer, causes the computer to execute any one of the aisle layout methods in the above embodiment.

In the above embodiments, it may be implemented in whole or in part by software, hardware, firmware or any combination thereof. When implemented in software, it can be implemented in whole or in part in the form of a computer program product. The computer program product includes one or more computer instructions. When the computer program instructions are loaded and executed on a computer, the processes or functions described in the embodiments of the present application are generated in whole or in part. The computer may be a general purpose computer, special purpose computer, computer network, or other programmable device. The computer instructions may be stored in a computer readable storage medium or transmitted from one computer readable storage medium to another computer readable storage medium, for example, the computer instructions may be transmitted from a website, computer, server or data center to another website, computer, server, or data center by wire (such as coaxial cable, fiber optic, digital subscriber line (DSL)) or wirelessly (such as infrared, wireless, microwave, etc.). The computer-readable storage medium may be any available medium that can be accessed by a computer or a data storage device such as a server and a data center and the like that includes an integration of one or more available medium. The available medium may be magnetic media (such as a floppy disk, a hard disk, a magnetic tape), optical media (such as DVD) and the like.

It should be noted that in this article, relational terms such as first and second are only to distinguish one entity or operation from another, and do not necessarily require or imply any actual relationship or order between these entities or operations. Moreover, the terms "include", "comprise", or any other variation thereof are intended to encompass a non-exclusive inclusion, such that a process, method, article, or device that includes a series of elements not only includes those elements, but also other elements that are not explicitly listed, or also include elements inherent in such a process, method, article, or device. Without further limitations, the elements limited by the statement "including one..." do not exclude the existence of other identical elements in the process, method, article, or device that includes the elements.

The various embodiments in this specification are described in a related manner, and the same or similar parts between the various embodiments can be referred to each other, and each embodiment focuses on the differences from other embodiments. In particular, for the embodiments of apparatus, electronic device, computer-readable storage medium, and computer program product, since these embodiments are basically similar to the embodiments of the method, the description is relatively simple, and the relevant points can be referred to the partial description of the method embodiment.

The above descriptions are only preferred embodiments of the present application, and are not intended to limit the present application. Any modifications, equivalent replacements, improvements, etc., made within the spirit and principles of the present application shall be included within the protection scope of the present application.

## Claims

1. An aisle layout method, comprising:
acquiring area distribution information and a rule for picking and placing goods of a warehouse area to be laid out; wherein, the area distribution information comprises: a passage position, a storage area position, and an obstacle position;
determining each storage location located in a storage area and each storage location located in an obstacle area between two obstacles and not belonging to any of storage areas according to the storage area position and the obstacle position;
performing, for each obstacle area, aisle layout on target adjacent storage locations of the obstacle area and at least one storage location in the obstacle area according to an aisle layout rule matching the rule for picking and placing goods, to obtain a laid-out first-type aisle;
wherein the target adjacent storage locations of each obstacle area comprise: each storage location located in an adjacent storage area on a designated side of the obstacle area, which is adjacent to the obstacle area and arranged in an arrangement direction of storage locations in the obstacle area; a shape of the first-type aisle comprises at least one of: a concave shape, an L shape, and a U shape.

2. The method according to claim 1, wherein the performing, for each obstacle area, aisle layout on target adjacent storage locations of the obstacle area and at least one storage location in the obstacle area according to an aisle layout rule matching the rule for picking and placing goods, to obtain a laid-out first-type aisle, comprises:
with the rule for picking and placing goods being first-in first-out, for each obstacle area, performing aisle layout on the target adjacent storage locations of the obstacle area and each storage location in the obstacle area according to an aisle layout rule of a first-type shape, to obtain the laid-out first-type aisle; wherein the first-type shape comprises: a concave shape;
with the rule for picking and placing goods being first-in last-out, for each obstacle area, performing aisle layout on the target adjacent storage locations of the obstacle area and each storage location in the obstacle area according to an aisle layout rule of a second-type shape, to obtain the laid-out first-type aisle; wherein the second-type shape comprises: a U shape, and/or, an L shape.

3. The method according to claim 2, wherein the performing aisle layout on the target adjacent storage locations of the obstacle area and each storage location in the obstacle area according to an aisle layout rule of a first-type shape, to obtain the laid-out first-type aisle, comprises:
determining any storage location, among the target adjacent storage locations of the obstacle area, that is adjacent to the passage position as a target aisle head;
determining a storage location, among the target adjacent storage locations, that is adjacent to the passage position other than the target aisle head as a target aisle tail;
determining, from among the target adjacent storage locations and each storage location in the obstacle area, each of target storage locations connecting the target aisle head and the target aisle tail and satisfying the rule for picking and placing goods, to obtain the laid-out first-type aisle of a concave shape; wherein the target storage locations comprise at least one storage location in the obstacle area.

4. The method according to claim 2, wherein the performing aisle layout on the target adjacent storage locations of the obstacle area and each storage location in the obstacle area according to an aisle layout rule of a second-type shape, to obtain the laid-out first-type aisle, comprises:
determining any storage location, among the target adjacent storage locations of the obstacle area, that is adjacent to the passage position as a target aisle head;
determining any storage location among storage locations in the obstacle area as a target aisle tail;
determining, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or an L shape; wherein the target storage locations comprise: all storage locations in the designated direction; the designated direction is: a direction from the target aisle tail pointing to an obstacle in the obstacle area that is farthest from the target aisle head.

5. The method according to claim 4, wherein the determining any storage location among storage locations in the obstacle area as the target aisle tail, comprises:
determining, from among the storage locations in the obstacle area, a storage location that is adjacent to an obstacle in the obstacle area and is closest to the target aisle head as the target aisle tail; wherein the shape of the obtained first-type aisle is the U shape;
or,
determining, from among the storage locations in the obstacle area, a storage location that is adjacent to an obstacle in the obstacle area and is farthest from the target aisle head as the target aisle tail; wherein the shape of the obtained first-type aisle is the L shape.

6. The method according to claim 5, wherein the determining, from among the storage locations in the obstacle area, a storage location that is adjacent to an obstacle in the obstacle area and is closest to the target aisle head as the target aisle tail, comprises:
in response to determining that a quantity of storage locations in the obstacle area is less than or equal to a designated quantity, determining, from among the storage locations in the obstacle area, a storage location that is adjacent to an obstacle in the obstacle area and is closest to the target aisle head as the target aisle tail;
the method further comprises:
in response to determining that the quantity of storage locations in the obstacle area is greater than the designated quantity, determining, from among the storage locations in the obstacle area, a storage location spaced from an obstacle closest to the target aisle head by a target quantity of storage locations as the target aisle tail; wherein the target quantity is: a difference between the quantity of storage locations and the designated quantity, and the shape of the obtained first-type aisle is the U shape or the L shape.

7. The method according to any one of claims 1-6, wherein the method further comprises:
performing, for each storage area, aisle division on each storage location in the storage area that has not been determined as a target storage location based on the rule for picking and placing goods and the passage position, to obtain each laid-out second-type aisle.

8. The method according to claim 7, wherein the rule for picking and placing goods is first-in first-out;
the performing, for each storage area, aisle division on each storage location in the storage area that has not been determined as a target storage location based on the rule for picking and placing goods and the passage position, to obtain a laid-out second-type aisle, comprises:
for each storage area, in response to determining that the storage area contains any of the target adjacent storage locations, dividing storage locations in the storage area into multiple groups of storage locations according to the arrangement direction; and dividing each group of storage locations that does not contain any of the target adjacent storage locations as a same aisle, to obtain each laid-out second-type aisle;
for each storage area, in response to determining that the storage area does not contain any of the target adjacent storage locations, dividing storage locations in the storage area into multiple groups of storage locations according to the arrangement direction; and dividing each group of storage locations as a same aisle, to obtain each laid-out second-type aisle.

9. The method according to claim 7, wherein the rule for picking and placing goods is first-in last-out, and there is an idle storage location among the target adjacent storage locations that has not been divided as the target storage location;
the performing, for each storage area, aisle division on each storage location in the storage area that has not been determined as the target storage location based on the rule for picking and placing goods and the passage position, to obtain each laid-out second-type aisle, comprises:
for each storage area, in response to determining that the storage area contains any of the target adjacent storage locations, dividing storage locations in the storage area into multiple groups of storage locations according to the arrangement direction; dividing the idle storage location and a group of storage locations adjacent to the idle storage location as a same L-shaped aisle, and dividing each group of storage locations that does not contain any of the target adjacent storage locations as a same aisle, to obtain each laid-out second-type aisle;
for each storage area, in response to determining that the storage area does not contain any of the target adjacent storage locations, dividing storage locations in the storage area into multiple groups of storage locations according to the arrangement direction; and dividing each group of storage locations as a same aisle, to obtain each laid-out second-type aisle.

10. An aisle layout apparatus, comprising:
an information acquisition module, configured to acquire area distribution information and a rule for picking and placing goods of a warehouse area to be laid out; wherein the area distribution information comprises: a passage position, a storage area position, and an obstacle position;
a storage location determination module, configured to determine each storage location located in a storage area and each storage location located in an obstacle area between two obstacles and not belonging to any of storage areas according to the storage area position and the obstacle position;
an aisle layout module, configured to perform, for each obstacle area, aisle layout on target adjacent storage locations of the obstacle area and at least one storage location in the obstacle area according to an aisle layout rule matching the rule for picking and placing goods, to obtain a laid-out first-type aisle; wherein the target adjacent storage locations of each obstacle area comprise: each storage location located in an adjacent storage area on a designated side of the obstacle area, which is adjacent to the obstacle area and arranged according to an arrangement direction of storage locations in the obstacle area; a shape of the first-type aisle comprises at least one of: a concave shape, an L shape, and a U shape.

11. The apparatus according to claim 10, wherein
the aisle layout module comprises:
a first layout sub-module, configured to, with the rule for picking and placing goods being first-in first-out, for each obstacle area, perform aisle layout on the target adjacent storage locations of the obstacle area and each storage location in the obstacle area according to an aisle layout rule of a first-type shape, to obtain the laid-out first-type aisle; wherein the first-type shape comprises: a concave shape;
a second layout sub-module, configured to, with the rule for picking and placing goods being first-in last-out, for each obstacle area, perform aisle layout on the target adjacent storage locations of the obstacle area and each storage location in the obstacle area according to an aisle layout rule of a second-type shape, to obtain the laid-out first-type aisle; wherein the second-type shape comprises: a U shape, and/or, an L shape.

12. The apparatus according to claim 11, wherein the first layout sub-module is specifically configured to:
determine any storage location adjacent to the passage position among the target adjacent storage locations of the obstacle area as a target aisle head;
determine storage locations adjacent to the passage position other than the target aisle head among the target adjacent storage locations as a target aisle tail;
determine each target storage location connecting the target aisle head and the target aisle tail and satisfying the rule for picking and placing goods among the target adjacent storage locations and each storage location in the obstacle area, to obtain the laid-out first-type aisle of the concave shape; wherein the target storage locations include at least one storage location in the obstacle area.

13. The apparatus according to claim 11, wherein the second layout sub-module comprises:
an aisle head determination unit, configured to determine any storage location, among the target adjacent storage locations of the obstacle area, that is adjacent to the passage position as a target aisle head;
an aisle tail determination unit, configured to determine any storage location among storage locations in the obstacle area as a target aisle tail;
an aisle determination unit, configured to determine, from among the target adjacent storage locations and storage locations in the obstacle area in a designated direction starting from the target aisle tail, each of target storage locations connecting the target aisle head and the target aisle tail and satisfying the rule for picking and placing goods, to obtain the laid-out first-type aisle of a U shape or a L shape; wherein the target storage locations comprise: all storage locations in the designated direction; the designated direction is: a direction from the target aisle tail pointing to an obstacle in the obstacle area that is farthest from the target aisle head.

14. The apparatus according to claim 13, wherein the aisle tail determination unit comprises:
a first determination sub-unit, configured to determine, from among the storage locations in the obstacle area, a storage location that is adjacent to an obstacle in the obstacle area and is closest to the target aisle head as the target aisle tail; wherein the shape of the obtained first-type aisle is the U shape;
or,
a second determination sub-unit, configured to determine, from among the storage locations in the obstacle area, a storage location that is adjacent to an obstacle in the obstacle area and is farthest from the target aisle head as the target aisle tail; wherein the shape of the obtained first-type aisle is the L shape.

15. The apparatus according to claim 14, wherein the first determination sub-unit is specifically configured to:
in response to determining that a quantity of storage locations in the obstacle area is less than or equal to a designated quantity, determine, from among the storage locations in the obstacle area, a storage location that is adjacent to an obstacle in the obstacle area and is closest to the target aisle head as the target aisle tail;
the apparatus further comprises:
an aisle tail determination module, configured to, in response to determining that the quantity of storage locations in the obstacle area is greater than the designated quantity, determine, from among the storage locations in the obstacle area, a storage location spaced from an obstacle closest to the target aisle head by a target quantity of storage locations as the target aisle tail; wherein the target quantity is: a difference between the quantity of storage locations and the designated quantity, and the shape of the obtained first-type aisle is the U shape, or, the L shape.

16. The apparatus according to any one of claims 10-15, wherein the apparatus further comprises:
an aisle division module, configured to, for each storage area, perform aisle division on each storage location in the storage area that has not been determined as a target storage location based on the rule for picking and placing goods and the passage position, to obtain each laid-out second-type aisle.

17. The apparatus according to claim 16, wherein the rule for picking and placing goods is first-in first-out; the aisle division module is specifically configured to:
for each storage area, in response to determining that the storage area contains any of the target adjacent storage locations, divide storage locations in the storage area into multiple groups of storage locations according to the arrangement direction; and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

18. The apparatus according to claim 16, wherein the rule for picking and placing goods is first-in last-out, and there is an idle storage location among the target adjacent storage locations that has not been divided as the target storage location; the aisle division module is specifically configured to:
for each storage area, in response to determining that the storage area contains any of the target adjacent storage locations, divide each storage location in the storage area into multiple groups of storage locations according to the arrangement direction; divide the idle storage location and an group of storage locations adjacent to the idle storage location as a same L-shaped aisle, and divide each group of storage locations that does not contain any of the target adjacent storage locations as a same aisle, to obtain each laid-out second-type aisle;
for each storage area, in response to determining that the storage area does not contain any of the target adjacent storage locations, divide storage locations in the storage area into multiple groups of storage locations according to the arrangement direction; and divide each group of storage locations as a same aisle, to obtain each laid-out second-type aisle.

19. An electronic device, comprising:
a memory, configured to store a computer program;
a processor, configured to execute the program stored in the memory to implement the method according to any one of claims 1-9.

20. A computer-readable storage medium, wherein the computer-readable storage medium has a computer program stored therein, wherein the computer program, when executed by a processor, implements the method according to any one of claims 1-9.

21. A computer program product containing instructions, wherein when the computer program product is run on a computer, causing the computer to execute the method according to any one of claims 1-9.
